# EUROPEAN PATENT SPECIFICATION

(11) **EP 4 381 303 B1**
(45) Date of publication and mention of the grant of the patent: **02.12.2026**
(21) Application number: 21787338.9
(22) Date of filing: 01.10.2021
(51) Int. Cl.: H01B 17/28, G01R 31/12, G01R 31/62, H01B 17/00

(54) **BUSHING AND A METHOD FOR MONITORING OF THE BUSHING**
BUCHSE UND VERFAHREN ZUR ÜBERWACHUNG DER BUCHSE
DOUILLE ET PROCÉDÉ DE SURVEILLANCE DE LA DOUILLE

(43) Date of publication of application: 12.06.2024
(73) Proprietor: HSP Hochspannungsgeräte GmbH, 53842 Troisdorf (DE)
(72) Inventor: NEGRI, Fabrizio, 90425 Nürnberg (DE)
(74) Representative: Betten & Resch
(86) International application number: PCT/EP2021/077059
(87) International publication number: WO 2023/051931

(56) References cited:
- DE-A1- 10 012 068
- US-A1- 2016 154 051
- EDILSON G PERES ET AL: "FIELD EXPERIENCE WITH ON-LINE DC BUSHING MONITORING IN HVDC SYSTEM AT IBIÚNA SUBSTATION", 1 January 2009 (2009-01-01), pages 1 - 8, XP055109412, Retrieved from the Internet <URL:http://www.treetech.com.br/en/artigos/HVDCUsers_Furnas_Ibiuna_MonitoracaoTrafoConversor_2009_ing.pdf> [retrieved on 20140324]
- SETAYESHMEHR A ET AL: "On-line monitoring and diagnoses of power transformer bushings", IEEE TRANSACTIONS ON DIELECTRICS AND ELECTRICAL INSULATION, IEEE SERVICE CENTER, PISCATAWAY, NJ, US, vol. 13, no. 3, 17 July 2006 (2006-07-17), pages 608 - 615, XP008119554, ISSN: 1070-9878, DOI: 10.1109/TDEI.2006.1657975
- XIAO YAO ET AL: "A Monitoring Scheme for UHV Wall Bushing", 2018 INTERNATIONAL CONFERENCE ON POWER SYSTEM TECHNOLOGY (POWERCON), IEEE, 6 November 2018 (2018-11-06), pages 4650 - 4654, XP033492392, DOI: 10.1109/POWERCON.2018.8602219

## Description

The present invention relates to a high-voltage DC bushing arrangement comprising a high-voltage DC bushing with a test or voltage tap.

The general purpose of a bushing is to allow an electrical conductor to pass through a conducting barrier such as a grounded wall or a housing of a transformer or a circuit breaker without an electrical flashover. High-voltage bushings are suitable to withstand the electrical field strength corresponding to voltages above 1 kV, and especially above 100 kV. They can thus be installed in high-voltage arrangements like e.g. HVDC systems. High-voltage DC (HVDC) bushings and high-voltage AC bushings are different due to the respective properties of the conducted current type. In particular, high-voltage DC bushings must be suitable for applications in systems with a considerable DC current/voltage portion of the conducted current. Some of the differences between AC and DC bushings are analyzed and described in X. Chen et al., "Electrical Properties Calculation of HVDC Bushing", 2010 Annual Report Conference on Electrical Insulation and Dielectric Phenomena.

High-voltage bushings, in particular capacitance graded bushings, may be provided with a test tap. The test tap can be also implemented by a voltage tap with integrated test tap functionality. A voltage tap is normally intended for use as a voltage divider during normal operation and may require the use of additional capacitance to limit the output voltage and protective devices e.g. mounted directly to the bushing. A test tap is intended for measurement of dissipation factor, capacitance from conductor to tap, and partial discharge on the field. The test tap is moreover designed to allow the testing of the bushing in the factory, therefore being usually grounded. Since the capacitance from tap to ground is not controlled, the tap is not necessarily intended for use as a voltage divider during normal operation. When not in use, the voltage and test taps are usually effectively grounded.

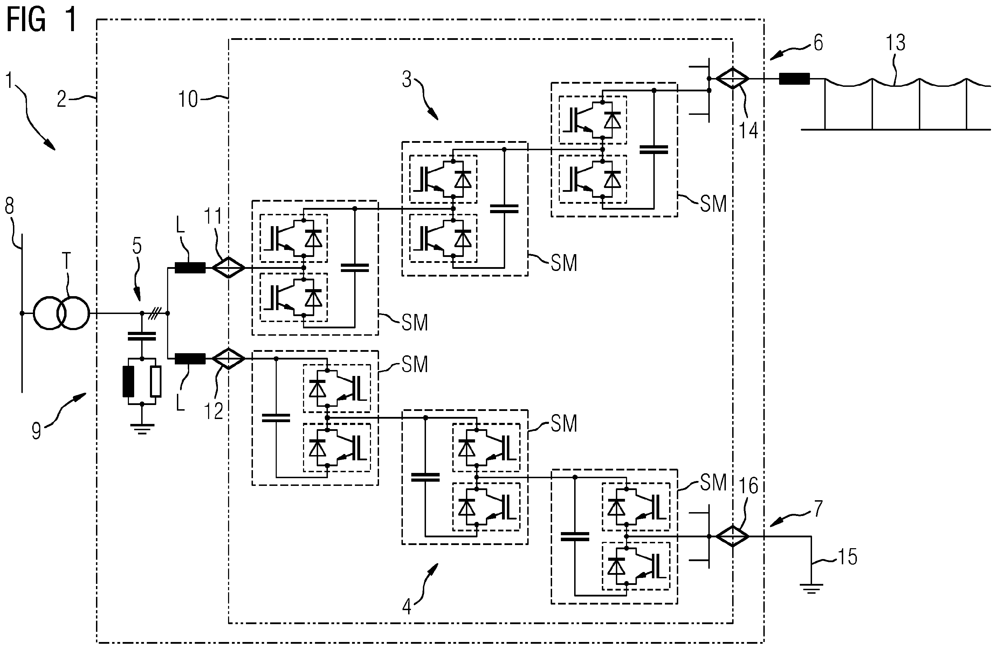

Figure 1 schematically shows an exemplary application of HVDC bushings in an HVDC VSC converter system 1. The converter system 1 comprises a converter 2 being a modular multi-level converter (MMC). The MMC comprises converter valves 3, 4, each arranged between an AC terminal 5 and one of two DC terminals 6, 7. The MMC is connected, via its AC terminal 5 and a converter transformer T, with an AC network 8. An AC filter unit 9 is arranged on the converter side of the converter transformer T. The converter valves 3, 4 of the MMC are located within a valve hall 10. To connect the series circuits of switching modules SM with smoothing reactors L located outside the valve hall 10, corresponding conductors are fed through a wall of the valve hall 10 via respective converter bushings 11, 12.

On the DC side of the MMC 2, the converter valve 3 is connected with a DC overhead line 13 (e.g. of positive polarity) via a first DC side bushing 14. Correspondingly, the converter valve 4 is connected with a grounded DC pole 15 via a second DC side bushing 16. Both, the converter bushings 11, 12, and the DC side bushings 14, 16, are high-voltage DC bushings in the sense of the present invention. The present invention can also be applied to the transformer bushings on the converter side of the Transformer T (not shown in the figure), which also are considered high-voltage DC bushings in the sense of the present invention. Even in presence of the filter unit 9, the voltage applied on the transformer bushings contains an AC and a DC component. For HVDC installations like the one shown in figure 1, the bushings are especially designed so that they are suitable for an alternating voltage, surge voltages as well as a stationary DC voltage. In particular, the bushings are exposed to DC voltages to ground. In general, the voltage stress withstand capability of the bushings is to be specified depending on their location and configuration of the HVDC system. The DC side bushing 14 in figure 1 is mainly expose to direct voltage and direct current, with a small amount of voltage and current harmonics.

Each of the converter valves 3, 4 comprises a series circuit of switching modules SM. According to the example of figure 1 the switching modules SM are half-bridge modules.

It is well known that a continuous monitoring of a bushing can increase its reliability, including its operating life.

A monitoring method for a high-voltage bushing is known from the EP 3 715 881 A1.

Peres et al., "Field Experience with On-Line Bushing Monitoring in HVDC System at Ibiuna Substation", 2009, describe an application of a monitoring system used in AC bushings to DC bushings.

US 2016/154051 A1 discloses systems and methods for measuring the integrity of insulation components in electrical systems.

The object of the present invention is therefore to provide an aforementioned high-voltage DC bushing arrangement as reliable as possible.

This object is achieved by a high-voltage DC bushing arrangement according to claim 1.

In accordance with the invention the high-voltage DC bushing arrangement comprises a monitoring means configured to inject a voltage and/or current pulse signal via the test or voltage tap (in the following generally referred to as tap) and to detect and process a corresponding response signal. In accordance with the teaching of the present invention a perturbation is applied to the system, whereas the system information contained in the response signal is examined. The DC bushing according to the present invention allows an efficient and effective monitoring of its status and health, thereby increasing the reliability of the DC bushing. It is understood that applying a combination of voltage/current pulses and analyzing a corresponding combined response signal also lies within the scope of the present invention.

The monitoring means comprises a pulse generator configured to generate said voltage and/or current pulse signal. The pulse generator is functionally connected with the tap. The pulse generated by the pulse generator can be injected into the tap. The response signal can be received using a separate link. Alternatively, the injected and the response signal can both be transmitted via a common link. The monitoring means can further comprise a receiving module for receiving and processing the response signal.

According to an embodiment of the invention the voltage and/or current pulse signal has a predetermined frequency distribution. Accordingly, the information about the bushing status can be extracted from the corresponding system frequency response.

Preferably, said voltage and/or current pulse signal comprises frequencies in the range between 30 Hz and 100 kHz.

According to the invention the monitoring means further comprises an (at least one) induction element in parallel to said pulse generator. In a simplified representation the DC bushing can be represented as a capacitance C between the corresponding HV line and the ground. The tap is then a pin dividing C into two partial capacitances C1 between the HV line and the tap and C2 between the tap and ground. Accordingly, the pulse generator is arranged as a parallel branch to C2. Usually, C2 is much larger than C1 (several thousands of pF compared to tens of pF). Being C2>>C1, the current or voltage pulse generated by the generator could skip capacitance C1 and close to ground directly via C2 at the tap (this happens because of the higher the capacitance, the lower the impedance). The parallel induction element effectively helps to avoid this. One can also apply different induction elements in parallel, to cut off different frequencies, for instance if a sinusoidal pulse is applied.

The induction element preferably has an induction value Lg which is chosen such that the impedance of a parallel circuit given by the induction element and a parallel capacitance of the bushing is substantially maximal for a signal frequency of said pulse signal. This can particularly be done by calculate Lg such that the impedance of the parallel circuit C2∥Lg tends to infinity (this happens when f=1/(2πsqrt(Lg * C2))).

According to a preferred embodiment of the invention the DC bushing further comprises an inner conductor, an insulating body that surrounds the inner conductor along its longitudinal direction, and comprising, insulating layers configured from a synthetic material or paper that is impregnated with a resin, and electrically conductive control inserts for field control, said control inserts being arranged in a concentric manner around the inner conductor, and spaced apart from one another by means of the insulating layers. Such capacitive control bushing provides particularly smooth field distribution and is therefore particularly effective and reliable. The test or voltage tap is preferably connected with one of said control inserts.

Another object of the present invention is to provide a method for operating a DC bushing arrangement comprising a high-voltage DC bushing with a test or a voltage tap which allows a most reliable operation of said bushing arrangement.

This object is achieved by a method according to claim 9. According to the invention, the method comprises the steps of injecting a voltage and/or current pulse signal via said tap of the DC bushing, detecting and processing a corresponding response signal, comparing the response signal with a predetermined calibrated reference signal, and providing a bushing status information based on said comparison.

Preferably, the response signal is frequency analyzed. The analysis may for example comprise a Fourier analysis of the response signal.

The resulting pulse is preferably decomposed by means of the Fourier analysis to obtain (extract) its frequency components. For every frequency component a related impedance is derived. For every frequency component (e.g. Hertz by Hertz) we can extract the related impedance (Z=V/I, per each frequency count). In this way, the corresponding impedance in the frequency domain can be derived. The impedance obtained in this way can be compared with reference lines coming from either tests or literature. Depending on the matching of the baseline with the measurement, inference on the status of the bushing can be made.

Another object of the present invention is to provide an HVDC transformer as reliable as possible.

This object is achieved by a transformer according to claim 12.

Yet another object of the present invention is to provide a converter arrangement as reliable as possible.

This object is achieved by a method according to claim 13. The converter arrangement according to the invention comprises a converter (e.g. an HVDC converter) with a first converter component located within a valve hall and a second converter component located outside said valve hall, wherein said first and said second components are electrically connected via at least one high-voltage DC bushing arrangement according to the present invention. The converter can be an MMC as described above. The first converter component can be a converter valve with a series of switching modules. The second converter component can be for example an HVDC transformer, a smoothing reactor, a DC terminal or any other component outside the valve hall.

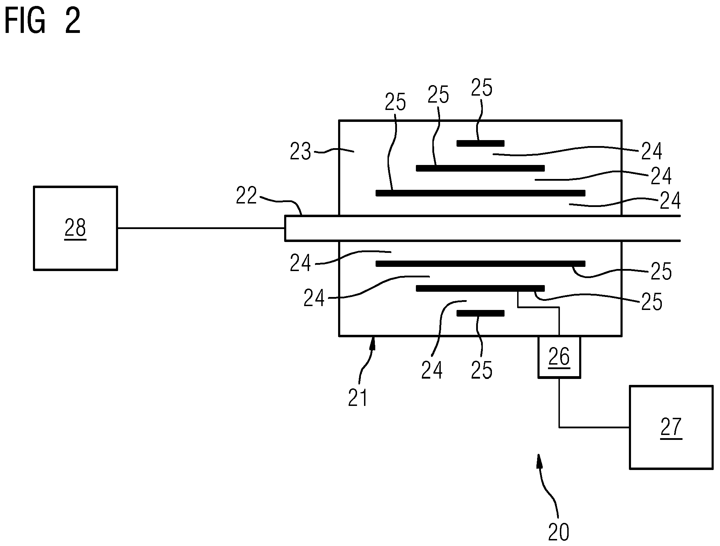

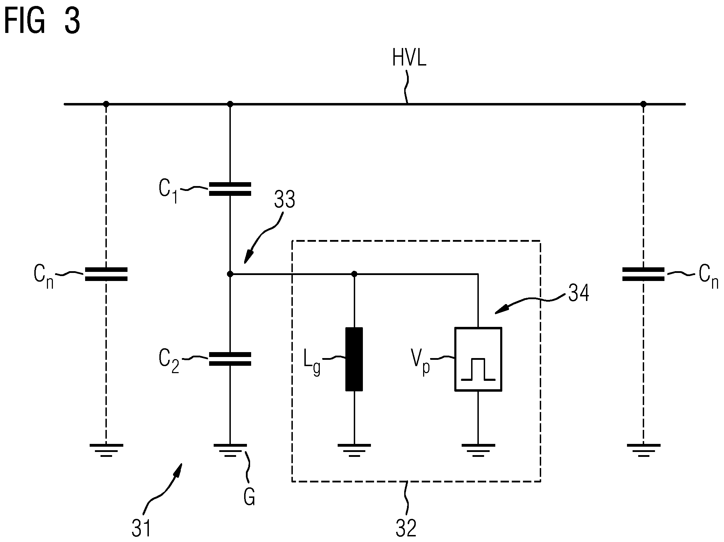

In the following the present invention is explained in more detail in accordance with an embodiment shown in the figures 2 and 3.

Figures 2 and 3 schematically show embodiments of a HVDC bushing arrangement according to the invention.

Figure 2 shows a bushing arrangement 20 with an HVDC bushing 21. The bushing 21 comprises an inner conductor 22 extending along a longitudinal axis of the bushing 21, an insulating body 23 that surrounds the inner conductor 22 along its longitudinal direction. The insulating body 23 comprises insulating layers 24 configured from a synthetic material or paper that is impregnated with a resin, and electrically conductive control inserts 25 for field control being spaced apart from one another by means of the insulating layers 24.

The bushing 21 further comprises a test tap 26 connected to one of the control inserts 25. A monitoring means 27 comprise a signal generator to generate a voltage pulse which can be injected in the test tap 26. Moreover, the monitoring means 27 is configured to receive and process a corresponding response signal transmitted from the test tap 26. In accordance with the example shown in figure 2 the bushing 21 is a transformer bushing to be connected with an HVDC transformer 28.

Figure 3 illustrates an HVDC bushing arrangement 31 comprising a bushing represented by two capacitances C1 and C2 serially arranged between a high-voltage line HVL and ground G. In operation, the inner conductor of the bushing is on the voltage level of the line HVL whereas a housing of the bushing is grounded. A stray HV-ground capacitance of the network is represented by a capacitance Cn.

The bushing arrangement 31 further comprises monitoring means 34. The monitoring means 34 is equipped with a pulse generator Vp configured to generate and transmit a voltage and/or current pulse signal to a test tap 33. In parallel to the pulse generator 32 an induction element Lg is provided, with an induction value calculated in a way that the impedance between C1 and ground tends to infinite resp. is maximal (according to f = 1 / (2*π*sqrt(Lg*C2), f denoting a pulse frequency). The current or voltage pulse signal can flow through C1 (the bushing main capacitance) and then close to ground via the stray capacitances of either the transformer or the HV network.

Since the current/voltage pulse flows on Cn capacitances, which may differ from case to case, the monitoring means preferably undergoes a pre-calibration before being used in operation (and from time to time an off-line calibration, e.g. every 5y in case of network configuration changes).

## Claims

1. High-voltage DC bushing arrangement (20, 31) comprising:
a high-voltage DC bushing (21) with a test or voltage tap (26, 33), and
a monitoring means (27, 34) configured to inject a voltage and/or current pulse signal via said tap (26, 33) and to detect and process a corresponding response signal,
charaterised in that wherein said monitoring means (27, 34) comprises a pulse generator (Vp) configured to generate said voltage and/or current pulse signal, and
wherein said monitoring means further comprises an induction element (Lg) in parallel to said pulse generator (Vp).

2. High-voltage DC bushing arrangement (20, 31) according to any of the preceding claims, wherein said voltage and/or current pulse signal has a predetermined frequency distribution.

3. High-voltage DC bushing arrangement (20, 31) according to any of the preceding claims, wherein said voltage and/or current pulse signal comprises frequencies in the range between 30 Hz and 100 kHz.

4. High-voltage DC bushing arrangement (20, 31) according to any of the preceding claims, wherein said induction element (Lg) has an induction value Lg is chosen such that the impedance of a parallel circuit given by the induction element (Lg) and a parallel capacitance (C2) of the bushing is substantially maximal for a signal frequency of said pulse signal.

5. High-voltage DC bushing arrangement (20, 31) according to any of the preceding claims, wherein said bushing further comprises
- an inner conductor (22),
- an insulating body (23) that surrounds the inner conductor (22) along its longitudinal direction, and comprising
- insulating layers (23) configured from a synthetic material or paper that is impregnated with a resin, and
- electrically conductive control inserts (25) for field control being spaced apart from one another by means of the insulating layers (24).

6. High-voltage DC bushing arrangement (20, 31) according to claim 5, wherein said tap (26) is connected with one of said control inserts (25).

7. Method for operating a bushing arrangement (20, 31) according to any preceding claims, comprising the steps of
- injecting a voltage and/or current pulse signal via a test or voltage tap of said high-voltage DC bushing,
- detecting and processing a corresponding response signal,
- comparing the response signal with a predetermined calibrated reference (signal), and
- providing a bushing status information based on said comparison.

8. Method of claim 7, wherein the response signal is frequency analyzed.

9. Method of claim 8, wherein resulting pulse frequency components are extracted from said response signal using a Fourier analysis, and for every frequency component a related impedance is derived.

10. High-voltage DC transformer (28) comprising a bushing arrangement (20) according to any one of claims 1 to 6.

11. Converter arrangement comprising:
at least one high-voltage DC bushing arrangement according to one of claims 1 to 6, and
a converter, with a first converter component located within a valve hall and a second converter component located outside said valve hall, wherein said first and said second components are electrically connected via the at least one high-voltage DC bushing arrangement.

## Patentansprüche

1. Hochspannungs-Gleichstrom-Durchführungsanordnung (20, 31) umfassend:
eine Hochspannungs-Gleichstrom-Durchführung (21) mit einem Prüf- oder Spannungsabgriff (26, 33), und
ein Überwachungsmittel (27, 34), das zum Injizieren eines Spannungs- und/oder Stromimpulssignals über den besagten Abgriff (26, 33) und zum Detektieren und Verarbeiten eines entsprechenden Antwortsignals ausgebildet ist,
**dadurch gekennzeichnet, dass** das besagte Überwachungsmittel (27, 34) einen Impulsgenerator (Vp) umfasst, der zum Generieren des besagten Spannungs- und/oder Stromimpulssignals konfiguriert ist, und
wobei das besagte Überwachungsmittel ferner ein Induktionselement (Lg) parallel zu besagtem Impulsgenerator (Vp) umfasst.

2. Hochspannungs-Gleichstrom-Durchführungsanordnung (20, 31) nach einem der vorhergehenden Ansprüche, wobei das besagte Spannungs- und/oder Stromimpulssignal eine vorbestimmte Frequenzverteilung aufweist.

3. Hochspannungs-Gleichstrom-Durchführungsanordnung (20, 31) nach einem der vorhergehenden Ansprüche, wobei das besagte Spannungs- und/oder Stromimpulssignal Frequenzen in dem Bereich zwischen 30 Hz und 100 kHz umfasst.

4. Hochspannungs-Gleichstrom-Durchführungsanordnung (20, 31) nach einem der vorhergehenden Ansprüche, wobei das besagte Induktionselement (Lg) einen Induktionswert Lg aufweist, der derart gewählt ist, dass die Impedanz eines Parallelschaltkreises, der durch das Induktionselement (Lg) und eine Parallelkapazität (C2) der Durchführung gegeben ist, im Wesentlichen maximal für eine Signalfrequenz des besagten Impulssignals ist.

5. Hochspannungs-Gleichstrom-Durchführungsanordnung (20, 31) nach einem der vorhergehenden Ansprüche, wobei die besagte Durchführung ferner umfasst:
- einen Innenleiter (22),
- einen Isolierkörper (23) der den Innenleiter (22) entlang seiner Längsrichtung umgibt, und umfassend:
- Isolierschichten (24) konfiguriert aus einem synthetischen Material oder Papier, das mit einem Harz imprägniert ist, und
- elektrisch leitfähige Steuereinlagen (25) zur Feldsteuerung, die mittels der Isolierschichten (24) voneinander beabstandet sind.

6. Hochspannungs-Gleichstrom-Durchführungsanordnung (20, 31) nach Anspruch 5, wobei der besagte Abgriff (26) mit einer der besagten Steuereinlagen (25) verbunden ist.

7. Verfahren zum Betreiben einer Durchführungsanordnung (20, 31) nach einem der vorhergehenden Ansprüche, umfassend die Schritte:
- Injizieren eines Spannungs- und/oder Stromimpulssignals über einen Prüf- oder Spannungsabgriff besagter Hochspannungs-Gleichstrom-Durchführung,
- Detektieren und Verarbeiten eines entsprechenden Antwortsignals,
- Vergleichen des Antwortsignals mit einer vorbestimmten kalibrierten Referenz (Signal), und
- Bereitstellen einer Durchführungsstatusinformation basierend auf dem besagten Vergleich.

8. Verfahren nach Anspruch 7, wobei das Antwortsignal frequenzanalysiert wird.

9. Verfahren nach Anspruch 8, wobei resultierende Impulsfrequenzkomponenten aus dem besagten Antwortsignal, unter Verwendung einer Fourier-Analyse extrahiert werden, und für jede Frequenzkomponente eine zugehörige Impedanz abgeleitet wird.

10. Hochspannungs-Gleichstrom-Transformator (28) umfassend eine Durchführungsanordnung (20) nach einem der Ansprüche 1 bis 6.

11. Stromrichteranordnung umfassend:
mindestens eine Hochspannungs-Gleichstrom-Durchführungsanordnung nach einem der Ansprüche 1 bis 6, und
einen Stromrichter, mit einer ersten Stromrichterkomponente, die innerhalb einer Ventilhalle lokalisiert ist und einer zweiten Stromrichterkomponente, die außerhalb besagter Ventilhalle lokalisiert ist, wobei die besagte erste und besagte zweite Komponente elektrisch über die mindestens eine Hochspannungs-Gleichstrom-Durchführungsanordnung verbunden sind.

## Revendications

1. Agencement (20, 31) de traversée à haute tension en courant continu, comprenant :
une traversée (21) à haute tension en courant continu, dotée d'une prise de test ou de tension (26, 33), et
un moyen de surveillance (27, 34), configuré de manière à injecter un signal d'impulsion de tension et/ou de courant via ladite prise (26, 33) et à détecter et traiter un signal de réponse correspondant,
**caractérisé en ce que** ledit moyen de surveillance (27, 34) comprend un générateur d'impulsions (Vp) configuré pour générer ledit signal d'impulsion de tension et/ou de courant, et
dans lequel ledit moyen de surveillance comprend en outre un élément d'induction (Lg) en parallèle avec ledit générateur d'impulsions (Vp).

2. Agencement (20, 31) de traversée à haute tension en courant continu selon l'une quelconque des revendications précédentes, dans lequel ledit signal d'impulsion de tension et/ou de courant présente une distribution de fréquences prédéterminée.

3. Agencement (20, 31) de traversée à haute tension en courant continu selon l'une quelconque des revendications précédentes, dans lequel ledit signal d'impulsion de tension et/ou de courant comprend des fréquences comprises entre 30 Hz et 100 kHz.

4. Agencement (20, 31) de traversée à haute tension en courant continu selon l'une quelconque des revendications précédentes, dans lequel ledit élément d'induction (Lg) a une valeur d'inductance Lg choisie de telle sorte que l'impédance d'un circuit parallèle constitué par l'élément d'induction (Lg) et une capacité parallèle (C2) de la traversée soit sensiblement maximale pour une fréquence de signal dudit signal impulsionnel.

5. Agencement (20, 31) de traversée à haute tension en courant continu selon l'une quelconque des revendications précédentes, dans lequel ladite traversée comprend en outre
- un conducteur interne (22),
- un corps isolant (23), qui entoure le conducteur interne (22) selon sa direction longitudinale, et comprenant
- des couches isolantes (24), constituées d'un matériau synthétique ou de papier imprégné de résine, et
- des inserts de commande (25) électriquement conducteurs, destinés à la commande de champ, qui sont espacés les uns des autres au moyen des couches isolantes (24).

6. Agencement (20, 31) de traversée à haute tension en courant continu selon la revendication 5, dans lequel ladite prise (26) est reliée à l'un desdits inserts de commande (25).

7. Procédé de mise en œuvre d'un agencement de traversée (20, 31) selon l'une quelconque des revendications précédentes, comprenant les étapes consistant à
- injecter un signal d'impulsion de tension et/ou de courant via une prise de test ou de tension de ladite traversée à haute tension en courant continu,
- détecter et traiter un signal de réponse correspondant,
- comparer le signal de réponse avec une référence (signal) calibrée prédéterminée, et
- fournir une information d'état de la traversée sur la base de ladite comparaison.

8. Procédé selon la revendication 7, dans lequel le signal de réponse fait l'objet d'une analyse fréquentielle.

9. Procédé selon la revendication 8, dans lequel les composantes de fréquence d'impulsion résultantes sont extraites dudit signal de réponse au moyen d'une analyse de Fourier, et pour chaque composante de fréquence, une impédance associée est déduite.

10. Transformateur (28) à haute tension en courant continu, comprenant un agencement de traversée (20) selon l'une quelconque des revendications 1 à 6.

11. Agencement de convertisseur comprenant :
au moins un agencement de traversée à haute tension en courant continu selon l'une des revendications 1 à 6, et
un convertisseur, avec un premier composant de convertisseur situé à l'intérieur d'une salle de valves et un deuxième composant de convertisseur situé à l'extérieur de ladite salle de valves, lesdits premier et deuxième composants étant connectés électriquement via ledit au moins un agencement de traversée à haute tension en courant continu.
